# EUROPEAN PATENT SPECIFICATION

(11) **EP 1 863 331 B1**
(45) Date of publication and mention of the grant of the patent: **29.09.2010**
(21) Application number: 06122541.3
(22) Date of filing: 18.10.2006
(51) Int. Cl.: H05K 13/08

(54) **Device to recognise mounted components**
Vorrichtung zur Erkennung von montierten Bauteilen
Dispositif pour reconnaître des composants montés

(30) Priority: 31.05.2006 ES 200601450
(43) Date of publication of application: 05.12.2007
(73) Proprietor: Emdep-3, S.L., 43813 Alio (ES)
(72) Inventor: Juan Antonio, Martínez Zambrana, 43800, Valls (Tarragona) (ES)
(74) Representative: Pons Ariño, Angel

(56) References cited:
- EP-A1- 0 355 377
- WO-A-95/21376
- US-A- 5 761 540
- US-A1- 2002 024 660

## Description

### OBJECT OF THE INVENTION

The present invention refers to a device for the recognition of components, those used in a vehicle, fitted into a fuse-box or similar.

The object of the invention focuses on a device that checks that inserted components, such as fuses, relays, etc., are the correct ones by means of recognition of the colors, shapes and graphic signals printed on them.

### BACKGROUND OF THE INVENTION

Industry in general, especially vehicle manufacturers, require their suppliers to guarantee that all supplied components comply with the requested technical specifications.

As for parts made up of components, like fuse boxes or similar, that also include a large number of specific components, these have to be correctly fitted into their corresponding location. The fuse box is a vital component of the vehicle, since all electrical conductions that compose its electrical system, precisely to protect it from short circuits, overvoltages and heating, pass through it. To this end, the fuse box will have to include a large number of fuses and other components, all of them independent and with specific features according to their function. In the case of fuses, each of them will have to be of a specific amperage, depending on the intensity of the current needed for each line.

Therefore, there are a large number of holes inside a fuse box to insert different components, into each of which must be placed the component with the specific characteristics indicated by the vehicle manufacturer in question.

Since component insertion is carried out in a mechanical way, there is the possibility that a wrong component may be fitted into the incorrect hole, such as a fuse with an amperage different from that required, or that the fuses are erroneously interchanged, which might lead to an important electrical problem in the vehicle, with the consequent economic losses that this entails.

The way to check the correct arrangement of each of the components in their respective holes is by using manual means, that is to say, that a workman verifies them, with the consequent rise in labour cost.

WO 95/213765 shows a device for imaging a three-dimensional object.

### DESCRIPTION OF THE INVENTION

The device to recognize components inserted into fuse boxes that the invention proposes, solves the aforementioned problem by having means to identify the inserted components by way of recognition of colors, shapes and graphic signals printed on them.

To this end, and in a more concrete way, the device is that of the type made up of a bed plate provided with a casing for the placing of the fuse box to be checked, and a viewing chamber, in the opposite position to the box, with means to protect the lens of the viewing chamber, a lighting system for optimum image capture, as well as a control unit that analyzes the image obtained and controls the device.

To protect the viewing chamber lens, the device has a plate with a window located on the viewing chamber, coinciding with the position of the chamber lens and provided with a guided sliding cover, activated by a pneumatic cylinder. The movement of the above-mentioned cover will close over the window, avoiding the entry of dust and foreign bodies that could damage the lens.

Another possibility to protect the lens of the viewing chamber is by means of an ultra-transparent glass window, placed over the viewing chamber.

In order to obtain a clear image from the viewing chamber, the device has a lighting system for optimum image capture, made up of an adjustable luminescent screen with a large number "led"-type diodes placed around the edge of the screen.

The means to regulate the luminescent screen consist of positioning guides fitted to the inner sides of the device on which the luminescent screen is fixed.

On the other hand, to orientate the luminescent screen towards the fuse box, it has an articulated arm fixed at one end to the side of the luminescent screen, and, on the other side, to the inner wall of the device, across the positioning guides.

Once the image has been obtained, the control unit, by means of a computer and suitable software, analyzes the image obtained to recognize and identify the colors, graphic symbols and shapes of the components inserted into the fuse box, and compares them to the specification patterns stored in the memory.

To detect possible deficient lighting, the device includes light sensors that detect the illumination in the fuse box.

Likewise, it has set positioning marks on the opposite surface to the viewing chamber to detect unforeseen movements of the viewing chamber that move the obtained image.

### DESCRIPTION OF THE DRAWINGS

To complete the description that is being given and in order to help give a better understanding of the invention's characteristics, with the idea to provide an essential example of its practical undertaking, a set of drawings with illustrative, not limitative character is attached as an integral part of the afore-mentioned description, showing the following:

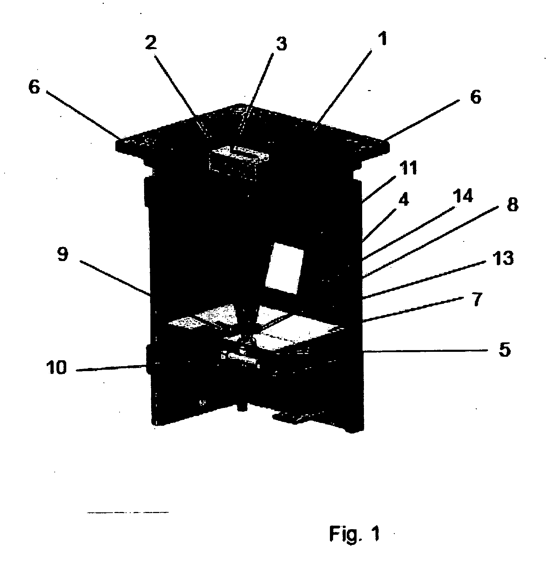

Figure 1 shows a partly-cut view of the device for the recognition of components inserted into a fuse-box, where the different elements that comprise it may be seen.
Figure 2 shows a view of the chamber lens protection device with its cover open.
Figure 3 shows the same view as the previous figure, but with the cover closed.
Figure 4 shows a partly-cut view of the luminescent screen.
Figure 5 shows a view of the opposite surface to the viewing chamber where it is possible to observe the layout of the lighting sensors and fixed positioning marks.

### PREFERRED EMBODIMENT OF THE INVENTION

In view of the outlined figures, it may be seen that the device for the recognition of components inserted into a fuse box or similar is made up of a bed plate 1 with a window-casing 2 for the placing of the fuse box 3 to be checked, and a viewing chamber 5, in the opposite position to the box 3, all fitted into a structure 4 that forms the device's casing. The above-mentioned structure is prepared to function as much as an independent module, as to be fitted onto a verification desk by screwing it in by means of the screw-holes 6.

Since the viewing chamber 5 is fitted to the lower part of the structure 4 and its lens is exposed to the entry of dust and foreign bodies through the window 2, the device has protective means comprising a plate 7 that covers the chamber 5 with a window 8 coinciding with the position of the chamber lens and provided with a guided sliding cover 9, activated by a pneumatic cylinder 10.

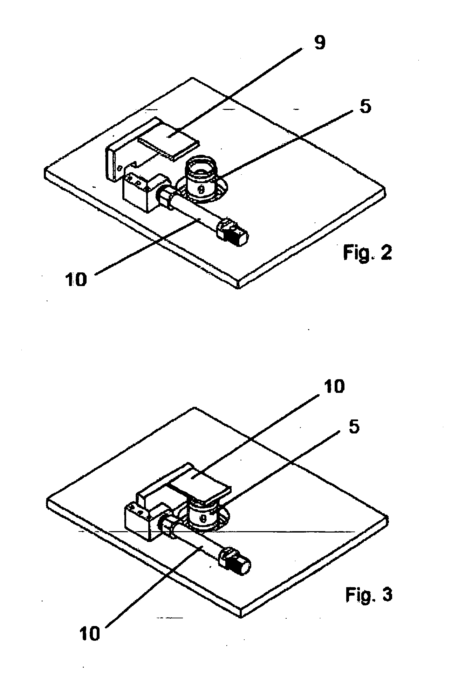

Thus, when the device is idle, the cover 9 will close over the window 8 to avoid the entry of dust and foreign bodies that could damage the lens of the chamber, just as shown in figure 3. When the device is to capture the image fuse holder 3, the pneumatic cylinder 10 will move the cover 9, leaving the window 8 open, just as may be observed in figure 8, closing again once the image has been captured.

In the current case of preferred embodiment of the invention, the chamber 5 is of "USB"-type.

An alternative to protect the viewing chamber lens 5, consists of fitting an ultra-transparent glass window that covers it, to substitute plate 7.

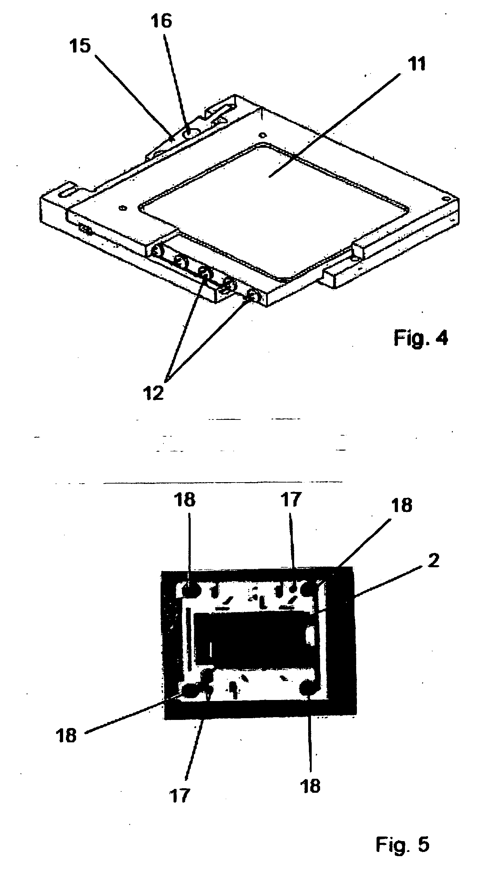

Image capture has to be carried out in a clear, sharp way, for which reason constant, homogeneous lighting over the whole surface to be examined is needed. To this end, the device includes a luminescent screen 11, with rectangular, flat configuration for its installation inside the structure 4. The above-mentioned screen is lit by several "led"-type diodes 12, laid out around the edge of the screen 11, just as may be seen in figure 4.

To fix and adjust the luminescent screen 11 inside the structure 4, there are positioning guides on the inner surface of the walls 14 with several holes, into which the screws to fasten the screen 11 will be inserted. Thus the screen 11 will be situated in the best location according to the characteristics of the fuse box 3 to illuminate.

Once the screen 11 is put in place, the next stage is its orientation, thanks to the existence of an articulated arm 15 fixed at one end to the side of the luminescent screen, and on the opposite side to the positioning guides 13, by means of screws that go through the holes 16. Thus, the inclination of the screen 11 may be varied to focus the illumination towards the plane making up the fuse box 3.

For the recognition of the components fitted into the fuse box, the device's control unit includes a computer, not shown in the drawings, that, using suitable software, analyzes the image obtained to recognize and identify the inserted components and their location by their colors, graphic symbols and shapes. Once their location has been identified and determined, they are compared to pattern of specifications saved in the memory to be validated or not. Where some anomaly is detected, the control unit will alert and report it for its correction.

In the same way, the control unit will include some light sensors 17 located on the opposite surface to the viewing chamber 5, near the window-casing 2, which will notify when a critical change affecting the precision of the device takes place in the illumination.

Finally, to correct possible deviations in image capture due to unforeseen movements of the viewing chamber 5, it has set positioning marks 18 on the opposite surface to the viewing chamber that enables the control unit to re-shift the obtained image.

Having sufficiently described the nature of the invention, as well as the way to undertake it in practice, it must be emphasized that the previously indicated layouts, represented in the attached drawings, may be modified as long as they do not alter the fundamental principle.

## Claims

1. Device for the recognition of components inserted into a fuse box, of the type made up of a bed plate (1) with a window-casing (2) for the placing of the fuse box (3) to be checked, and a viewing chamber (5) in the opposite position to the box, the device having viewing-chamber lens protection means (7-10), a lighting system for optimum image capture, in addition to a control unit to analyze the image obtained and control the device.

2. Device to recognize the components inserted into a fuse box, according to claim 1, **characterized by** the viewing chamber lens protection means having a plate (7) with a window (8) located on the viewing chamber, coinciding with the position of the chamber lens and provided with a guided sliding cover (9), activated by a pneumatic cylinder (10).

3. Device to recognize the components inserted into a fuse box, according to claim 1, **characterized by** the viewing chamber lens protection means consisting of an ultra-transparent glass window over the viewing chamber.

4. Device to recognize the components inserted into a fuse box, according to claim 1, **characterized by** the lighting system for optimum image capture being made up of an adjustable luminescent screen (11) wish several "led"-type diodes (12) arranged around the screen.

5. Device to recognize the components inserted into a fuse box, according to claim 4, **characterized by** the means to regulate the luminescent screen consisting of positioning guides (13) fitted to the inner sides of the device onto which the luminescent screen is fixed.

6. Device to recognize the components inserted into a fuse box, according to claim 4, **characterized by** the means to regulate the luminescent screen consisting of an articulated arm (15) fixed at one end to the side of the luminescent screen and at the other end to the inner wall (14) of the device across the positioning guides.

7. Device for the recognition of the components inserted into a fuse box, according to claim 1, **characterized by** the control unit including a computer and suitable software to analyze the image obtained to recognize and identify the colors, graphic symbols and shapes of the components inserted into the fuse box, comparing them to the specification patterns saved in the memory.

8. Device to recognize the components inserted into a fuse box, according to claim 1, **characterized by** having light sensors (17) to detect the fuse box light level.

9. Device to recognize the components inserted into a fuse box, according to claim 1, **characterized by** having set positioning marks (18) on the opposite surface to the chamber to detect unforeseen movements of the viewing chamber that move the obtained image.

## Patentansprüche

1. Gerät zur Erkennung der in einen Sicherungskasten eingesetzten Bauteile, bestehend aus einer Grundplatte (1) mit einem Fensterrahmen (2) zum Einsetzen des zu untersuchenden Sicherungskastens (3) und einer Beobachtungskammer (5) auf der gegenüberliegenden Seite des Kastens, einer Schutzvorrichtung für die Linse der Beobachtungskammer (7-10), einem Beleuchtungssystem zur optimalen Bilderfassung, zusätzlich zu einer Steueranlage zur Auswertung des erhaltenen Bildes und zur Steuerung des Geräts.

2. Gerät zur Erkennung der in einen Sicherungskasten eingesetzten Bauteile gemäß Patenanspruch 1, **gekennzeichnet durch** die Schutzvorrichtung für die Linse der Beobachtungskammer, bestehend aus einer Platte (7) mit einem Fenster (8) an der Beobachtungskammer, und zwar an derselben Stelle wie die Linse der Kammer und ausgestattet mit einer gesteuerten Schiebeabdeckung (9), die über einen Pneumatikzylinder (10) betätigt wird.

3. Gerät zur Erkennung der in einen Sicherungskasten eingesetzten Bauteile gemäß Patentanspruch 1, **gekennzeichnet durch** die Schutzvorrichtung für die Linse der Beobachtungskammer, bestehend aus einem ultra-transparenten Glasfenster auf der Beobachtungskammer.

4. Gerät zur Erkennung der in einen Sicherungskasten eingesetzten Bauteile gemäß Patentanspruch 1, **gekennzeichnet durch** das Beleuchtungssystem für eine optimale Bilderfassung, bestehend aus einem anpassbaren Leuchtschirm (11) mit mehreren "LED"-Dioden (12), die um den Schirm herum angeordnet sind.

5. Gerät zur Erkennung der in einen Sicherungskasten eingesetzten Bauteile gemäß Patentanspruch 4, **gekennzeichnet durch** die Vorrichtung zur Regulierung des Leuchtschirms, bestehend aus an den Innenseiten des Geräts angebrachten Positionierführungen (13), auf die der Leuchtschirm montiert ist.

6. Gerät zur Erkennung der in einen Sicherungskasten eingesetzten Bauteile gemäß Patentanspruch 4, **gekennzeichnet durch** die Vorrichtung zur Regulierung des Leuchtschirms, bestehend aus einem Gelenkarm (15), der an einem Ende an der Seite des Leuchtschirms und am anderen Ende an der inneren Wand (14) des Geräts auf den Positionierführungen angebracht ist.

7. Gerät zur Erkennung der in einen Sicherungskasten eingesetzten Bauteile gemäß Patentanspruch 1, **gekennzeichnet durch** die Steueranlage, einschließlich Computer und geeigneter Software zur Auswertung des erhaltenen Bildes, um die Farben, die Grafiksymbole und die Formen der in den Sicherungskasten eingesetzten Bauteile zu erkennen und zu bestimmen und mit den auf der Speicherkarte gespeicherten Spezifikationen zu vergleichen.

8. Gerät zur Erkennung der in einen Sicherungskasten eingesetzten Bauteile gemäß Patentanspruch 1, **gekennzeichnet durch** Lichtsensoren (17) zum Ermitteln des Lichtpegels im Sicherungskasten.

9. Gerät zur Erkennung der in einen Sicherungskasten eingesetzten Bauteile gemäß Patentanspruch 1, **gekennzeichnet durch** die Kennzeichnung von Positionsmarkierungen (18) auf der der Kammer gegenüber liegenden Fläche, um ein unvorhergesehenes Bewegen der Beobachtungskammer festzustellen, welches das erhaltene Bild verwackeln würde.

## Revendications

1. Dispositif pour la reconnaissance de composants insérés dans une boîte à fusibles, du type constitué d'une plaque d'assise (1), avec un boîtier à fenêtre (2) pour la mise en place de la boîte à fusibles (3) devant être contrôlée, et une chambre d'observation (5) dans la position opposée à la boîte, le dispositif possédant des organes (7-10) de protection de la lentille de la chambre d'observation, un système d'éclairage pour une capture d'image optimale, en plus d'une unité de contrôle pour analyser l'image obtenue et contrôler le dispositif.

2. Dispositif pour reconnaître les composants insérés dans une boîte à fusibles, selon la revendication 1, **caractérisé par** l'organe de protection de la lentille de la chambre d'observation possédant une plaque (7) avec une fenêtre (8) située sur la chambre d'observation, coïncidant avec la position de la lentille de la chambre et comportant un cache (9) coulissant guidé, activé par un cylindre pneumatique (10).

3. Dispositif pour reconnaître les composants insérés dans une boîte à fusibles, selon la revendication 1, **caractérisé par** l'organe de protection de la lentille de la chambre d'observation consistant en une fenêtre en verre ultra-transparent sur la chambre d'observation.

4. Dispositif pour reconnaître les composants insérés dans une boîte à fusibles, selon la revendication 1, **caractérisé par** le système d'éclairage pour une capture d'image optimale étant constitué d'un écran luminescent réglable (11) avec plusieurs diodes de type « DEL » (12) disposées autour de l'écran.

5. Dispositif pour reconnaître les composants insérés dans une boîte à fusibles, selon la revendication 4, **caractérisé par** les organes de réglage de l'écran luminescent constitués de guides (13) de positionnement montés sur les côtés internes du dispositif sur lesquels l'écran luminescent est fixé.

6. Dispositif pour reconnaître les composants insérés dans une boîte à fusibles, selon la revendication 4, **caractérisé par** les organes de réglage de l'écran luminescent constitués d'un bras articulé (15) fixé à une extrémité au côté de l'écran luminescent et à l'autre extrémité à la paroi interne (14) du dispositif sur les guides de positionnement.

7. Dispositif pour la reconnaissance des composants insérés dans une boîte à fusibles, selon la revendication 1, **caractérisé par** l'unité de contrôle comprenant un ordinateur et un logiciel approprié pour analyser l'image obtenue afin de reconnaître et d'identifier les couleurs, les symboles graphiques et les formes des composants insérés dans la boîte à fusibles, en les comparant aux modèles de spécifications stockés en mémoire.

8. Dispositif pour reconnaître les composants insérés dans une boîte à fusibles, selon la revendication 1, **caractérisé par le fait qu'**il possède des capteurs de lumière (17) pour détecter le niveau de lumière de la boîte à fusibles.

9. Dispositif pour reconnaître les composants insérés dans une boîte à fusibles, selon la revendication 1, **caractérisé par le fait que** des marques de positionnement (18) y sont apposées sur la surface opposée à la chambre afin de détecter des mouvements imprévus de la chambre d'observation qui font bouger l'image obtenue.
